Europäisches Patentamt

European Patent Office

Office européen des brevets

(19)

(11) **EP 0 698 952 B1**

(12) **FASCICULE DE BREVET EUROPEEN**

(45) Date de publication et mention
de la délivrance du brevet:
**22.10.1997 Bulletin 1997/43**

(51) Int Cl.6: **H01S 3/109**, G02F 1/37,
G02F 1/39, H01S 3/085

(21) Numéro de dépôt: **95401583.0**

(22) Date de dépôt: **30.06.1995**

(54) **Source optique compacte, basée sur le doublage de fréquence d'un laser**

Auf der Frequenzverdopplung eines Lasers basierende kompakte optische Quelle

Compact optical source based on frequency doubling of a laser

(84) Etats contractants désignés:
**DE GB NL**

(30) Priorité: **05.07.1994 FR 9408288**

(43) Date de publication de la demande:
**28.02.1996 Bulletin 1996/09**

(73) Titulaire: **THOMSON-CSF**
**75008 Paris (FR)**

(72) Inventeurs:
• **Delacourt, Dominique**
**F-92402 Courbevoie Cedex (FR)**
• **Papuchon, Michel**
**F-92402 Courbevoie Cedex (FR)**

(74) Mandataire: **Guérin, Michel et al**
**THOMSON-CSF-S.C.P.I.,**
**13, Avenue du Président**
**Salvador Allende**
**94117 Arcueil Cédex (FR)**

(56) Documents cités:
**EP-A- 0 314 171** **EP-A- 0 576 197**
**WO-A-90/04867**

• **APPLIED PHYSICS LETTERS, vol. 58, no. 20, 20 Mai 1991 NEW YORK, US, pages 2203-2204, XP 000241207 K.A.STANKOV '25ps Pulses from a Nd:YAG Laser Mode Locked by a Frequency Doubling beta-BaB2O4 Crystal'**
• **APPLIED PHYSICS LETTERS, vol. 62, no. 21, 24 Mai 1993 NEW YORK, US, pages 2599-2601, XP 000303716 K.YAMAMOTO ET AL. 'High Power Blue Light Generation by Frequency Doubling of a Laser Diode in a Periodically Domain-Inverted LiTaO3 Waveguide'**
• **Journal of Applied Physics, 71(1992)1, pp.22-27**

**Description**

Le domaine de l'invention est celui des sources optiques compactes, capables d'émettre dans des domaines spectraux que l'absence de matériaux lasers adaptés ou la difficulté pour les obtenir pourraient interdire, et ce grâce à des opérations de conversion de fréquence.

En effet, en utilisant la susceptibilité non linéaire d'ordre deux de certains matériaux tels que par exemple le niobate de lithium ($LiNbO_3$), on peut à partir d'une illumination dans le proche infrarouge, émettre dans la région bleue du spectre, grâce au phénomène de doublage de fréquence.

Dans l'opération de doublage de fréquence, pour que soit efficace le transfert de puissance optique à partir de l'illumination incidente à la longueur d'onde $\lambda$, il est nécessaire que dans le matériau et tout au long de l'interaction, la polarisation non linéaire induite par l'onde incidente soit en accord de phase avec l'onde créée à la longueur d'onde $\lambda/2$ et que l'on cherche à alimenter. Cependant, en général et du fait de la dispersion des indices de réfraction du matériau à $\lambda^\omega$ et $\lambda^\omega/2$, cette condition d'accord de phase n'est pas satisfaite d'emblée.

Pour contourner cet obstacle, une première solution consiste à mettre à profit la biréfringence de certains matériaux afin de compenser leur dispersion d'indice. Il existe également une solution alternative qui consiste à utiliser le Quasi-Accord de Phase (Q A P) applicable dans des conditions beaucoup plus générales que celles concernant la biréfringence de certains matériaux. Cette solution alternative consiste à perturber périodiquement l'interaction non linéaire afin de compenser la différence de vecteur d'onde responsable du désaccord de phase.

Plus précisément, soit une onde incidente, se propageant suivant l'axe Ox dans le matériau non linéaire et de champs électriques

$$E\omega = E\omega,o\ e^{j(\omega t - \beta_\omega x + \phi p_o)}$$

de longueur d'onde $\lambda^\omega = 2\pi.c/\omega$
avec $\beta_\omega$ constante de propagation de l'onde de pompe
et $\beta_\omega = 2\pi n_\omega/\lambda^\omega$
c: la célérité de la lumière dans le vide
$\omega$ : la fréquence

Dans un matériau adapté, cette onde peut donner naissance à une polarisation non linéaire d'ordre 2, s'écrivant

$$P_{NL} = \varepsilon_o\ d\ E_{\omega^2} = \varepsilon_o\ d\ E_{\omega,o^2}e^{j(2\omega t - 2\beta_\omega x + 2\phi_{po})}$$

où d est le coefficient non linéaire mis en jeu et $\varepsilon_o$ la permittivité diélectrique du vide.

Cette polarisation rayonne une onde à fréquence double susceptible de construire au fur et à mesure de l'interaction, un faisceau harmonique de longueur d'onde moitié $\lambda^{2\omega} = \lambda^\omega/2$ et de constante de propagation $\beta_{2\omega}$ avec $\beta_{2\omega} = 2\pi\ n_{2\omega}/\lambda^{2\omega}$ où $n_{2\omega}$ est l'indice du matériau à la longueur d'onde $\lambda^{2\omega}$ ; le champ électrique correspondant à cette onde peut s'écrire

$$E_{2\omega} = E_{2\omega,o\ e}{}^{j(2_\omega t - \beta_{2\omega} x + \phi_{ho})}$$

Il apparaît ainsi que le déphasage $\Delta\phi$ entre la polarisation non linéaire qui constitue la source du rayonnement à $\lambda^{2\omega}$, et l'onde harmonique que l'on cherche à alimenter de manière constructive à l'aide de cette polarisation, va jouer un rôle décisif dans la conversion $\lambda^\omega \dashrightarrow \lambda^{2\omega}$. En fait ce déphasage s'exprime au bout d'une distance x d'interaction, de la manière suivante :

$$\Delta\phi = (\beta_{2\omega} - 2\beta_\omega)x = \Delta\beta x$$

avec $\Delta\beta = 4\pi\ (n_{2\omega} - n_\omega)\lambda^\omega = 4\pi\Delta n/\lambda^\omega$
Il apparaît bien qu'en raison de la dispersion des indices, ce déphasage n'est généralement pas nul.

Cependant on peut créer une variation périodique $\Delta\beta = m.K$ ou $K = 2\pi/\Lambda$ avec période de la perturbation, et $\Lambda = 2L_C$ si $L_C$ est la longueur de cohérence correspondant à la distance d'interaction au bout de laquelle polarisation et onde harmonique ont accumulé un déphasage de $\pi$.

La perturbation peut être introduite au niveau de tout paramètre intervenant dans l'interaction non linéaire (indice de réfraction, dispersion des indices, coefficient non linéaire mis en jeu ...).

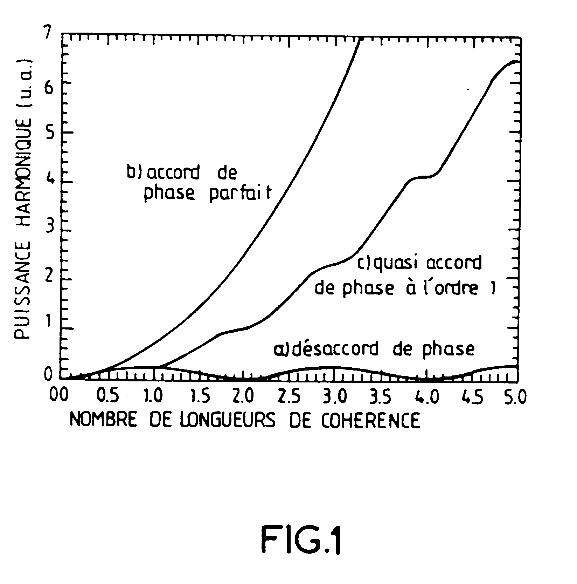

Grâce à cette perturbation périodique, le déphasage $\Delta\phi$ entre polarisation et onde harmonique se voit diminuer de $\pi$ au bout de chaque $L_C$, c'est-à-dire qu'au lieu de continuer à s'accumuler, il est ramené à 0, toutes les longueurs de cohérence. La figure 1 illustre à ce titre les trois cas possibles : courbe a) désaccord de phase, courbe b) : quasi accord de phase, courbe c) : accord de phase parfait.

L'objet de l'invention concerne une source utilisant un laser émettant une onde incidente à $\lambda^\omega$ de manière à générer par l'intermédiaire d'un doubleur de fréquence une onde $\lambda^{2\omega}$; le doubleur de fréquence étant un milieu non linéaire (MNL) dans lequel la condition d'accord de phase, ou la condition de quasi accord de phase est réalisée à la longueur d'onde $\lambda^\omega$.

La source selon l'invention permet de résoudre le problème de la largeur spectrale d'émission du laser, ce phénomène étant prononcé dans le cadre de diode laser, alors que les conditions d'accord de phase ou de quasi accord de phase ne sont satisfaits dans le milieu (MNL) que pour certaines longueurs d'onde très précises. Pour cela la source compacte selon l'invention utilise le "verrouillage" de la longueur d'émission du laser en injectant à ce dernier un signal de longueur d'onde identique à celle pour laquelle la condition d'accord de phase ou de quasi accord de phase est assurée.

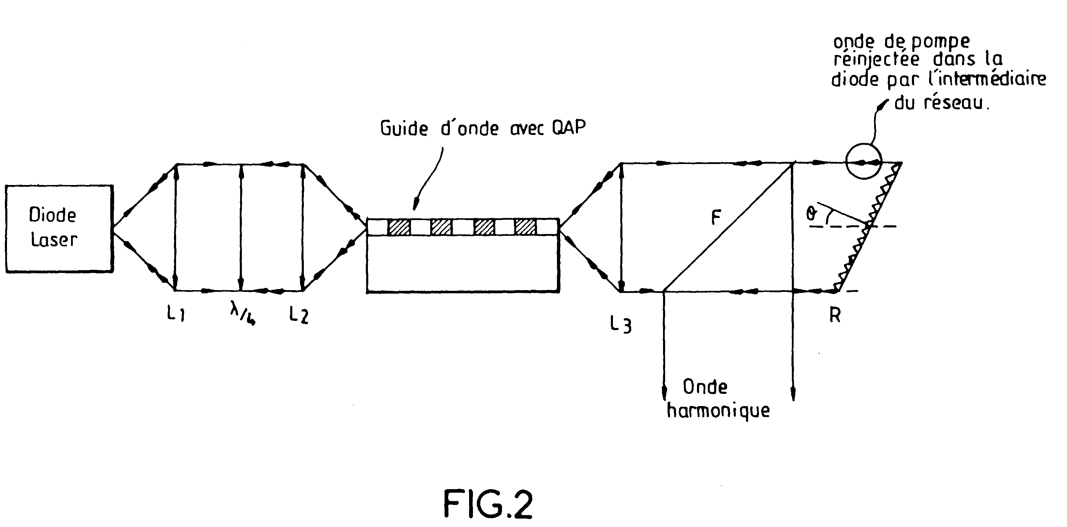

Cette notion de "verrouillage" correspondant au fait d'injecter un signal optique au sein d'un laser et notamment d'une diode laser, pour verrouiller la longueur d'onde d'émission de cette diode, sur celle du signal injecté a déjà fait l'objet de publication. C'est ainsi que les auteurs de la référence (High power blue light generation by frequency doubling of a laser diode in a periodically domain-inserted LiTaO$_3$ wave guide K. Yamamoto, K. Mizuuchi, Y. Kitaoka and M. Kato, Appl. Phys. Lett. 62 (21), 24 May 1993) ont fait varier continûment la longueur d'onde d'émission d'une diode laser monofréquence en ré-injectant au sein de cette diode, son propre faisceau mais après réflexion sur un réseau dispersif, la diode n'ayant pas nécessairement subi de traitement anti-reflet sur la face de sortie. Le schéma de principe de cette expérience destinée au doublage de fréquence d'une diode laser par quasi-accord de phase (Q A P) dans un guide d'onde non linéaire est représenté à la figure 2. La rotation du réseau permet de faire varier la longueur d'onde réinjectée dans la diode laser et donc de contrôler la longueur d'onde d'émission de cette dernière (dans ce cas autour de 860 nm) pour obtenir l'accord voulu.

L'inconvénient majeur de ce type de technique réside dans le fait que l'accord désiré n'est pas obtenu de manière automatique et donc qu'une contre-réaction supplémentaire est nécessaire pour que le système fonctionne de manière satisfaisante. Il faut, dans l'exemple cité ici, asservir la position du réseau à la puissance harmonique émise, afin de suivre une variation potentielle de la longueur d'onde de Q A P du doubleur, par exemple sous l'effet de la température extérieure.

Dans la demande de brevet internationale WO 90 04867, d'autres auteurs ont également envisagé de verrouiller automatiquement la longueur d'onde d'une diode laser qui émet une onde incidente sur la longueur d'onde pour laquelle la condition d'accord de phase est satisfaite.

L'objet de l'invention est de rendre possible le verrouillage automatique de la longueur d'onde de la diode laser sur la longueur d'onde pour laquelle la condition d'accord de phase ou de quasi accord de phase est satisfaite, au niveau du doubleur de fréquence.

Pour cela, le principe de l'invention consiste à recycler dans le composant non linéaire (MNL) ayant servi au doublage de fréquence, la majeure partie de l'onde harmonique accompagnée d'une faible partie de l'onde de pompe (onde incidente qui génère la polarisation non linéaire) résiduelle, en favorisant l'amplification paramétrique au détriment du doublage de fréquence.

Il est en effet possible d'obtenir dans le composant non linéaire, l'amplification de la petite partie de l'onde de pompe recyclée mais ce, uniquement si sa longueur d'onde correspond à celle de la condition d'accord de phase ou Q A P dans le composant non linéaire. En ré-injectant le signal optique issu de cette amplification, on verrouille la longueur d'onde de la diode à la valeur exacte qui permet le meilleur rendement de conversion entre la puissance issue de la diode laser et la puissance harmonique qui correspond à la puissance de sortie de la source proposée.

Pour mettre en oeuvre ce principe, l'invention a pour objet une source optique compacte, comprenant une diode laser émettant une onde incidente dans une gamme de longueurs d'ondes $\lambda o_i$ et un milieu non linéaire (MNL) dans lequel la condition d'accord de phase ou la condition de quasi accord de phase permettant d'annuler ou de compenser la différence de constante de propagation existant entre la polarisation non linéaire créée par l'onde incidente d'une part et une onde harmonique engendrée par cette polarisation d'autre part est réalisé à la longueur d'onde $\lambda o_a$ appartenant à l'ensemble des $\lambda o_i$, dans le milieu non linéaire (MNL) ;

caractérisée en ce que :

- la source optique comprend pour verrouiller automatiquement la longueur d'onde de la diode laser sur la longueur d'onde $\lambda_{oa}$ pour laquelle la condition d'accord de phase ou de quasi accord de phase est satisfaite également deux miroirs dichroïques $M_1$ et $M_2$ situés de telle façon que l'on a la succession suivante d'éléments : la diode laser émettre, le miroir $M_1$, le milieu non linéaire (MNL), le miroir $M_2$, lesdits miroirs $M_1$ et $M_2$ étant fortement transparents aux longueurs d'onde $\lambda o_i$ et fortement réfléchissants aux longueurs d'onde $\lambda o_i/2$, de manière à réinjecter dans la diode laser une onde à $\lambda o_a$ et récupérer au niveau de $M_1$ une onde à $\lambda o_a/2$, et

-  en ce que le miroir $M_2$ est tel qu'il introduit un déphasage $\phi_h$ sur l'onde harmonique et un déphasage $\phi_p$ sur l'onde de pompe tels que : $2\phi_p - \phi_h = \pm \pi$ pour favoriser l'amplification paramétrique au détriment du doublage de fréquence.

La condition d'accord de phase peut être assurée par la biréfringence du milieu (MNL) dans certaines gammes de longueurs d'onde, avec certains milieux non linéaires type $LiNbO_3$. Lorsque l'on est dans des conditions d'accord de phase au niveau du matériau (MNL), le miroir $M_2$ peut avantageusement introduire un déphasage $\phi_h$ sur l'onde harmonique et un déphasage $\phi_p$ sur l'onde de pompe tels que $2\phi_p - \phi_h = \pm \pi$ pour favoriser l'amplification paramétrique au détriment du doublage de fréquence dans le sens dit "RETOUR".

Pour des longueurs d'ondes d'émission non compatibles avec les matériaux non linéaires biréfringents classiques, la condition de quasi accord de phase peut être assurée par une variation périodique d'un paramètre physique du milieu (MNL), intervenant dans l'interaction non linéaire entre la polarisation non linéaire créée et l'onde harmonique. Le laser utilisé dans le dispositif peut avantageusement être une diode laser. Au moins un des miroirs $M_1$ ou $M_2$ peut avantageusement être intégré au milieu (MNL).

Le milieu (MNL) peut avantageusement comprendre un guide d'onde dont les faces d'entrée et de sortie sont traitées pour réaliser les miroirs $M_1$ et $M_2$.

Le milieu (MNL) peut avantageusement être du type tantalate de lithium ($LiTaO_3$) ou de type niobate de lithium ($LiNbO_3$) ou de type phosphate de potassium et de titanyl (KTP).

L'invention sera mieux comprise et d'autres avantages apparaîtront à la lecture de la description qui va suivre et des figures annexées parmi lesquelles :

-  la figure 1 illustre l'évolution de la puissance harmonique en fonction de la distance d'interaction dans les cas :

a) de désaccord de phase
b) d'accord de phase parfait
c) de quasi accord de phase

-  la figure 2 illustre un dispositif de source compacte selon l'art connu ;
-  la figure 3 illustre un dispositif de source compacte selon l'invention ;
-  la figure 4 illustre l'évolution spectrale du signal à $\lambda^\omega$, en fonction de la longeur d'onde d'émission :

*  la figure 4a est relative à l'onde lumineuse initiale ;
*  la figure 4b est relative à l'onde lumineuse issue du milieu (MNL) dans le sens "Retour" ;

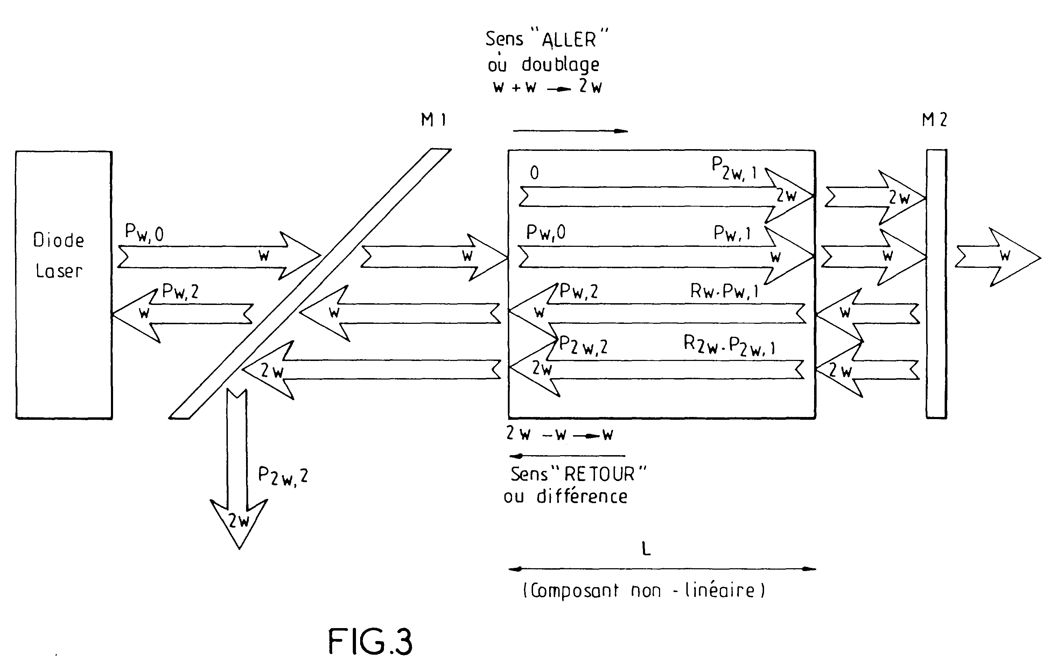

Une des configurations possibles pour réaliser la source compacte selon l'invention est schématisée à la figure 3.

Une diode laser (DL) émet un faisceau lumineux avec une puissance $P_{\omega,o}$ à la longueur d'onde $\lambda^\omega$. Après traversée d'un miroir dichroïque M1 transparent à $\lambda^\omega$, le faisceau lumineux rentre dans le milieu non linéaire (MNL), la puissance $P_{\omega,o}$ devient en sortie du milieu une puissance $P_{\omega,1}$ une partie de ce faisceau ayant servi à créer de l'onde harmonique $P_{2\omega,1}$ en sortie du milieu (MNL). Un second miroir dichroïque $M_2$ fortement transparent à $\lambda^\omega$ et fortement réfléchissant à $\lambda^{2\omega}$ est placé en sortie du milieu (MNL) de manière à faire interagir dans un sens dit retour, le faisceau réfléchi de puissance $P_{2\omega,1}$ avec la faible partie du faisceau à $\lambda^\omega$ qui a été réfléchie par $M_2$ soit $P_{\omega,1} \cdot R_\omega$ ($R_\omega$ étant le coefficient de réflexion de $M_2$ à la longueur d'onde $\lambda^\omega$, $R_{2\omega}$ étant le coefficient de réflexion de $M_2$ à la longueur d'onde $\lambda^{2\omega}$).

La configuration illustrée, comprend un milieu non linéaire (MNL), dans lequel la condition de quasi accord de phase est satisfaite à la longueur d'onde $\lambda^\omega = \lambda_{oa}$, en ayant réalisé au sein dudit milieu une structure réseau.

Ainsi dans le sens "retour", on peut obtenir de l'amplification paramétrique du signal de pompe en réalisant certaines conditions sur les déphasages introduits par le miroir $M_2$ au niveau de l'onde créée à $\lambda^{2\omega}$ et de l'onde de pompe à $\lambda^\omega$.

Soit

$\phi_{po}$ la phase de l'onde pompe
$\phi_{ho}$ la phase de l'onde harmonique lors de l'opération de doublage de fréquence on

$$2\phi_{po} - \phi_{ho} = -\pi/2 \qquad ①$$

lors de l'opération d'amplification paramétrique on a

$$2\phi_{po} - \phi_{ho} = +\pi/2 \qquad ②$$

Ainsi dans le sens "Aller", l'opération de dépeuplement de la pompe au profit de la création de photons à la fréquence $2\omega$ se fait au dépens de l'amplification paramétrique et la condition ① est satisfaite. Pour inverser ce processus et satisfaire la condition ② dans le sens "retour", il est souhaitable que le miroir $M_2$ génère des déphasages $\phi_p$ et $\phi_h$ respectivement sur l'onde de pompe et l'onde harmonique tels que

$$2\phi_p - \phi_h = \pm\pi \qquad ③.$$

Dans le cas du Q A P, où l'onde harmonique et la polarisation générée par l'onde de pompe ne sont pas en phase, en tout point de l'interaction, l'équation ③ reste dans la plupart des cas toujours valable ; néanmoins pour de très forts dépeuplements de pompe elle devra plutôt être écrite $2\phi_p - \phi_h = \phi$ avec $\phi$ pouvant décroître jusqu'à 0.

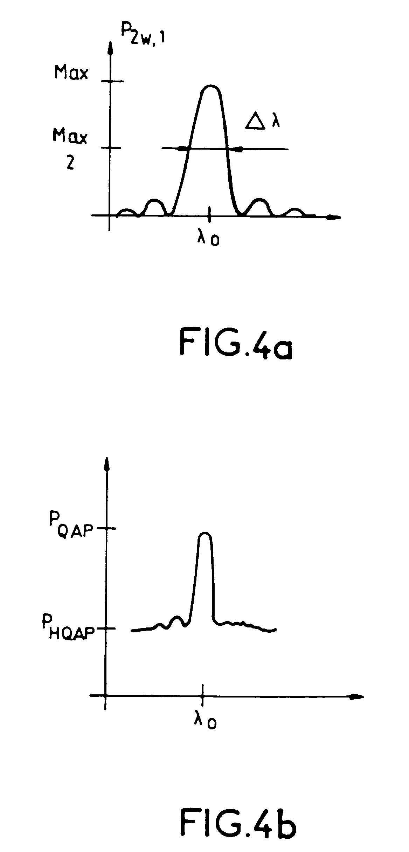

Le résultat de l'amplification paramétrique générée dans le sens "Retour" est un signal optique dont l'évolution spectrale, en fonction de la longueur d'onde d'émission de la diode est donnée à la figure 4b.

Cette figure illustre bien comment il est possible de verrouiller l'émission de la diode en y injectant un signal qui n'est significatif que lorsque la longueur d'onde d'émission est exactement celle pour laquelle la condition d'accord de phase ou de quasi accord de phase est satisfaite.

En sortie "Retour" du milieu (MNL), l'onde à $\lambda^\omega$ de puissance $P_{\omega 2}$ est réinjectée dans la diode après passage au travers du miroir dichroïque $M_1$, fortement transparent à $\lambda^\omega$, alors que l'onde à $\lambda^{2\omega}$ est récupérée au niveau dudit miroir, puisque celui-ci est fortement réfléchissant à la longueur d'onde $\lambda^{2\omega}$, avec une puissance $P_{2\omega,2}$.

<u>Exemple d'application concernant une source bleue de longueur d'onde 430 nm</u>

A partir d'une diode laser émettant dans le proche infrarouge à 860 nm, type diode GaAs/GaAlAs, il est possible de réaliser l'opération de doublage de fréquence au travers d'un guide d'onde réalisé sur tantalate de lithium dans lequel a été gravé une structure réseau par échange protonique. La référence (1) citée précédemment décrit un tel composant où le réseau nécessaire pour satisfaire à la condition de quasi accord de phase est obtenu par retournement du coefficient non linéaire ($d_{33}$) mis en jeu.

Compte tenu du matériau et de la longueur d'onde de pompe considérés, la période permettant la condition (Q A P) est de 3,95 $\mu$m, l'acceptance spectrale théorique étant de 0.086 nm.cm (0, 86 Angstroems.cm), puisqu'étant inversement proportionnelle à la longueur d'interaction Lc.

L'efficacité expérimentale du doublage de fréquence publiée en référence (1) correspond à un rendement normalisé $\eta = P_{2\omega}/P_\omega^2 . L^2$. Ce rendement est évalué à 230 % W.cm², en ne tenant pas compte du dépeuplement de la pompe.

En réalisant un miroir $M_2$ en matériau diélectrique d'épaisseur de l'ordre de quelques milliers d'Angstroëms (1 Angstroem $\approx$ 0.1 nm; il peut s'agir d'une couche déposée en sortie du tantalate de lithium) de coefficient de réflexion $R_\omega = 0,01$ nous obtenons pour une puissance d'onde de pompe $P_{\omega,0} = 100$ mW à partir du rendement de conversion normalisé et selon des calculs classiques les puissances $P_{2\omega,1}$ ; $P_{\omega,2}$ ; $P_{2\omega,2}$ regroupées dans le tableau ci-dessous.

| L (cm) | $P_{\omega,1}$ | $P_{2\omega,1}$ | $R_\omega.P_{\omega,1}$ | $P_{\omega,2}$ | $P_{2\omega,2}$ |
|---|---|---|---|---|---|
| 1 | 80,2 | 19,8 | 0,802 | 1,23 | 19,4 |
| 2 | 44,8 | 55,2 | 0,448 | 1,85 | 53,8 |
| 3 | 20,3 | 79,7 | 0,203 | 2,61 | 77,3 |

Avec du cristal de KTP (à préciser), il est possible d'atteindre des rendements $\eta$ voisins de 80 % W.cm² comme l'indiquent certains auteurs ("Very high efficiency of frequency doubling in QPM waveguides of KTP" D. Eger, M. Oron, M. Katz and A. Zussman Paper CHTB1 in Technical digest of Compact blue/green lasers, SALT LAKE CITY, February 1994). A partir d'une puissance $P_{\omega,0} = 100$ mW on peut atteindre une puissance $P_{2\omega,2} \sim 49,5$ mW grâce au dispositif selon l'invention.

**Revendications**

1.  Source optique compacte, comprenant une diode laser émettant une onde incidente dans une gamme de lon-

gueurs d'ondes $\lambda o_i$ et un milieu non linéaire (MNL) dans lequel la condition d'accord de phase ou la condition de quasi accord de phase permettant d'annuler ou de compenser la différence de constante de propagation existant entre la polarisation non linéaire créée par l'onde incidente d'une part et une onde harmonique engendrée par cette polarisation d'autre part est réalisée à la longueur d'onde $\lambda o_a$ appartenant à l'ensemble des $\lambda o_i$, dans le milieu non linéaire (MNL) ;
   caractérisée en ce que :

- la source optique comprend pour verrouiller automatiquement la longueur d'onde de la diode laser sur la longueur d'onde $\lambda o_a$ pour laquelle la condition d'accord de phase ou de quasi accord de phase est satisfaite également deux miroirs dichroïques $M_1$ et $M_2$ situés de telle façon que l'on a la succession suivante d'éléments : la diode laser émetteur, le miroir $M_1$, le milieu non linéaire (MNL), le miroir $M_2$, lesdits miroirs $M_1$ et $M_2$ étant fortement transparents aux longueurs d'onde $\lambda o_i$ et fortement réfléchissants aux longueurs d'onde $\lambda o_i/2$, de manière à réinjecter dans la diode laser une onde à $\lambda o_a$ et récupérer au niveau de $M_1$ une onde à $\lambda o_a/2$, et
- en ce que le miroir $M_2$ est tel qu'il introduit un déphasage $\phi_h$ sur l'onde harmonique et un déphasage $\phi_p$ sur l'onde de pompe de la diode laser tels que : $2\phi_p - \phi_h = \pm\pi$ pour favoriser l'amplification paramétrique au détriment du doublage de fréquence.

2. Source optique compacte selon la revendication 1, caractérisée en ce que la condition d'accord de phase dans le milieu (MNL) est assurée par la biréfringence du milieu (MNL).

3. Source optique compacte selon l'une des revendications 1 ou 2, caractérisée en ce que la condition d'accord de phase est assurée par la modulation spatiale périodique d'un paramètre physique du milieu non linéaire (MNL) intervenant dans l'interaction non linéaire entre la polarisation non linéaire créée et l'onde harmonique.

4. Source optique compacte selon la revendication 3, caractérisée en ce que le paramètre modulé périodiquement est le coefficient non linéaire $d_{33}$.

5. Source optique compacte selon l'une des revendications 1 à 4, caractérisée en ce que le milieu (MNL) est un guide d'onde.

6. Source optique compacte selon l'une des revendications 1 à 5, caractérisée en ce que $\lambda o_a$ est voisine de 430 nm, le laser émettant dans le proche infrarouge (vers 860 nm).

7. Source optique compacte selon l'une des revendications 1 à 6, caractérisée en ce que le milieu (MNL) est du tantalate de lithium ($LaTiO_3$).

8. Source optique compacte selon l'une des revendications 1 à 6, caractérisée en ce que le milieu (MNL) est du phosphate de potassium et de titanyl (KTP).

9. Source optique compacte selon l'une des revendications 1 à 6, caractérisée en ce que le milieu (MNL) est du niobate de lithium ($LiNbO_3$).

10. Source optique compacte selon l'une des revendications 1 à 9, caractérisée en ce qu'au moins un des deux miroirs est intégré au milieu (MNL).

**Patentansprüche**

1. Kompakte optische Quelle mit einer Laserdiode, die eine Eingangswelle in einem Wellenlängenbereich $\lambda_{oi}$ emittiert, und mit einem nicht-linearen Milieu (MNL), in dem die Bedingung der Phasenabstimmung oder Quasi-Phasenabstimmung, bei der der Unterschied in der Ausbreitungskonstante zwischen der durch die Eingangswelle erzeugten nicht-linearen Polarisation einerseits und einer durch diese Polarisation erzeugten Oberwelle andererseits annulliert oder kompensiert werden kann, bei der Wellenlänge $\lambda_{oa}$, die zum Wellenlängenbereich $\lambda_{oi}$ gehört, in dem nicht-linearen Milieu (MNL) erreicht wird, dadurch gekennzeichnet, daß die optische Quelle zur automatischen Verriegelung der Wellenlänge der Laserdiode auf die Wellenlänge $\lambda_{oa}$, für die die Bedingung der Phasenabstimmung oder Quasi-Phasenabstimmung erfüllt ist, außerdem zwei dichroitische Spiegel ($M_1$ und $M_2$) besitzt, die so angeordnet sind, daß sich die folgende Abfolge von Elementen ergibt: emittierende Laserdiode, Spiegel

$M_1$, nicht-lineares Milieu (MNL), Spiegel $M_2$, wobei die beiden Spiegel $M_1$ und $M_2$ im Wellenlängenbereich $\lambda_{oi}$ stark transparent und im Wellenlängenbereich $\lambda_{oi}/2$ stark reflektierend sind, so daß in die Laserdiode eine Welle mit der Wellenlänge $\lambda_{oa}$ zurückgespeist wird und am Spiegel $M_1$ eine Welle der Wellenlänge $\lambda_{oa}/2$ abgenommen werden kann, und daß der Spiegel $M_2$ so ausgebildet ist, daß er eine Phasenverschiebung $\varphi_h$ in der Oberwelle und eine Phasenverschiebung $\varphi_p$ in der Pumpwelle der Laserdiode derart bildet, daß gilt $2\varphi_p - \varphi_h = \pm\pi$, um die parametrische Verstärkung zu Lasten der Frequenzverdopplung zu begünstigen.

2.  Kompakte optische Quelle nach Anspruch 1, dadurch gekennzeichnet, daß die Bedingung der Phasenabstimmung in dem nicht-linearen Milieu (MNL) durch die Doppelbrechung des Milieus (MNL) gewährleistet ist.

3.  Kompakte optische Quelle nach einem der Ansprüche 1 und 2, dadurch gekennzeichnet, daß die Bedingung der Phasenabstimmung durch die periodische räumliche Modulation eines physikalischen Parameters des nicht-linearen Milieus (MNL) gewährleistet ist, der bei der nicht-linearen Wechselwirkung zwischen der erzeugten nicht-linearen Polarisation und der Oberwelle wirksam wird.

4.  Kompakte optische Quelle nach Anspruch 3, dadurch gekennzeichnet, daß der periodisch modulierte Parameter der nicht-lineare Koeffizient $d_{33}$ ist.

5.  Kompakte optische Quelle nach einem der Ansprüche 1 bis 4, dadurch gekennzeichnet, daß das nicht-lineare Milieu (MNL) ein Lichtwellenleiter ist.

6.  Kompakte optische Quelle nach einem der Ansprüche 1 bis 5, dadurch gekennzeichnet, daß die Wellenlänge $\lambda_{oa}$ bei etwa 430 nm liegt, wobei dann der Laser im nahen Infrarot (bei etwa 860 nm) emittiert.

7.  Kompakte optische Quelle nach einem der Ansprüche 1 bis 6, dadurch gekennzeichnet, daß das nicht-lineare Milieu (MNL) Lithiumtantalat ($LaTiO_3$) ist.

8.  Kompakte optische Quelle nach einem der Ansprüche 1 bis 6, dadurch gekennzeichnet, daß das nicht-lineare Milieu (MNL) Kalium- und Titanylphosphat (KTP) ist.

9.  Kompakte optische Quelle nach einem der Ansprüche 1 bis 6, dadurch gekennzeichnet, daß das nicht-lineare Milieu (MNL) Lithiumniobat ($LiNbO_3$) ist.

10. Kompakte optische Quelle nach einem der Ansprüche 1 bis 9, dadurch gekennzeichnet, daß mindestens einer der beiden Spiegel in das nicht-lineare Milieu (MNL) integriert ist.

## Claims

1.  Compact optical source, comprising a laser diode emitting an incident wave within a range of wavelengths $\lambda o_i$ and a non-linear material (NLM) in which the phase-tuning condition or quasi-phase-tuning condition allowing cancellation of or compensation for the difference in propagation constant existing between, on the one hand, the non-linear polarization created by the incident wave and, on the other hand, a harmonic wave generated by this polarization is achieved in the non-linear medium (NLM) at a wavelength $\lambda o_a$ belonging to the set of $\lambda o_i$ values; characterized in that:

    -   the optical source also comprises, in order automatically to lock the wavelength of the laser diode onto the wavelength $\lambda o_a$ for which the phase-tuning condition or quasi-phase-tuning condition is satisfied, two cichroic mirrors $M_1$ and $M_2$ placed in such a way that there is the following succession of elements: the emitter laser diode, the mirror $M_1$, the non-linear medium (NLM), the mirror $M_2$, the said mirrors $M_1$ and $M_2$ being highly transparent at the wavelengths $\lambda o_i$ and highly reflecting at the wavelengths $\lambda o_i/2$, so as to reinject into the laser diode a wave at $\lambda o_a$ and recover at $M_1$ a wave at $\lambda o_a/2$, and
    -   in that the mirror $M_2$ is such that it introduces a phase shift $\phi_h$ in the harmonic wave and a phase shift $\phi_p$ in the pump wave of the laser diode, these phase shifts being such that $2\phi_p - \phi_h = \pm\pi$ in order to favour parametric amplification to the detriment of frequency doubling.

2.  Compact optical source according to Claim 1, characterized in that the phase-tuning condition in the medium (NLM) is provided by the birefringence of the medium (NLM).

3. Compact optical source according to either of Claims 1 and 2, characterized in that the phase-tuning condition is provided by the periodic spatial modulation of a physical parameter of the non-linear medium (NLM) involved in the non-linear interaction between the non-linear polarization created and the harmonic wave.

4. Compact optical source according to Claim 3, characterized in that the periodically modulated parameter is the non-linear coefficient $d_{33}$.

5. Compact optical source according to one of Claims 1 to 4, characterized in that the medium (NLM) is a waveguide.

6. Compact optical source according to one of Claims 1 to 5, characterized in that $\lambda o_a$ is close to 430 nm, the laser emitting in the near infrared (about 860 nm).

7. Compact optical source according to one of Claims 1 to 6, characterized in that the medium (NLM) is lithium tantalate ($LiTaO_3$).

8. Compact optical source according to one of Claims 1 to 6, characterized in that the medium (NLM) is potassium titanyl phosphate (KTP).

9. Compact optical source according to one of Claims 1 to 6, characterized in that the medium (NLM) is lithium niobate ($LiNbO_3$).

10. Compact optical source according to one of Claims 1 to 9, characterized in that at least one of the two mirrors is integrated into the medium (NLM).

FIG.1

Guide d'onde avec QAP

onde de pompe
réinjectée dans la
diode par l'intermédiaire
du réseau.

Diode
Laser

L1  λ/4  L2

L3

F

θ

R

Onde
harmonique

FIG.2

Sens "ALLER"
ou doublage
$w + w \longrightarrow 2w$

M1

M2

$\longrightarrow$

Diode
Laser

$P_{w,0}$

$w$

$P_{w,2}$

$w$

$2w$

$P_{2w,2}$

$2w$

$0$

$P_{2w,1}$

$2w$

$P_{w,0}$

$P_{w,1}$

$w$

$P_{w,2}$

$R_w \cdot P_{w,1}$

$w$

$P_{2w,2}$

$R_{2w} \cdot P_{2w,1}$

$2w$

$2w$

$2w$

$w$

$w$

$2w$

$2w$

$w$

$2w \longrightarrow w \longrightarrow w$

Sens "RETOUR"
ou différence

L

(Composant non - linéaire)

FIG.3

FIG.4a

FIG.4b